# EUROPÄISCHE PATENTSCHRIFT

(11) **EP 4 049 517 B1**
(45) Veröffentlichungstag und Bekanntmachung des Hinweises auf die Patenterteilung: **06.11.2024**
(21) Anmeldenummer: 20786451.3
(22) Anmeldetag: 24.09.2020
(51) Int. Cl.: H01R 4/44, H01R 4/46, H05K 7/14, H05K 7/20

(54) **ANORDNUNG MIT ELEKTROGERÄT, INSBESONDERE UMRICHTER ODER WECHSELRICHTER, UND KOMPONENTE**
ARRANGEMENT WITH ELECTRICAL DEVICE, IN PARTICULAR CONVERTER OR INVERTER, AND COMPONENT
AGENCEMENT DOTÉ D'UN APPAREIL ÉLECTRIQUE, EN PARTICULIER UN CONVERTISSEUR OU UN ONDULEUR, ET COMPOSANT

(30) Priorität: 21.10.2019 DE 102019007312
(43) Veröffentlichungstag der Anmeldung: 31.08.2022
(73) Patentinhaber: SEW-EURODRIVE GmbH & Co. KG, 76646 Bruchsal (DE)
(72) Erfinder: FRANK, Horst, 76684 Östringen-Odenheim (DE); KOLLAR, Hans Jürgen, 76646 Bruchsal (DE); WETZEL, Thomas, 76698 Ubstadt-Weiher (DE)
(86) Internationale Anmeldenummer: PCT/EP2020/025432
(87) Internationale Veröffentlichungsnummer: WO 2021/078401

(56) Entgegenhaltungen:
- DE-A1- 102016 004 976
- DE-U1- 29 610 613
- US-A1- 2004 056 631
- US-A1- 2012 019 987

## Beschreibung

Die Erfindung betrifft eine Anordnung mit Elektrogerät, insbesondere Umrichter oder Wechselrichter, und Komponente.

Es ist allgemein bekannt, dass ein Elektrogerät Verlustwärme erzeugt und diese über einen Kühlkörper an die Umgebung abführbar ist.

**Aus der** US 2004/056631 A1 **ist als nächstliegender Stand der Technik eine Anordnung mit Elektorgerät bekannt.**

**Aus der** DE 10 2016 004 976 A1 **ist eine Haltevorrichtung bekannt.**

**Aus der** DE 296 10 613 U1 **ist ein Anschlussmittel für Leitungen einer industriellen Steuerung bekannt.**

**Aus der** US 2012/019987 A1 **ist eine Steuerungsanordnung bekannt.**

Der Erfindung liegt daher die Aufgabe zugrunde, eine Anordnung mit Elektrogerät weiterzubilden, wobei eine kostengünstige kompakte Ausführung erreichbar sein soll.

Erfindungsgemäß wird die Aufgabe bei der Anordnung nach den in Anspruch 1 angegebenen Merkmalen gelöst.

Wichtige Merkmale bei der Anordnung mit Elektrogerät, insbesondere Umrichter oder Wechselrichter, und Komponente sind, dass das Elektrogerät einen Kühlkörper aufweist,
wobei am Kühlkörper ein Grundblech befestigt ist und die Komponente mit einem am Grundblech befestigten, ersten oder zweiten Adapterblech verbunden ist,
insbesondere wobei das Grundblech vom Schraubenkopf einer in eine Gewindebohrung des Kühlkörpers eingeschraubten Schraube an den Kühlkörper angedrückt ist.

Von Vorteil ist dabei, dass das Grundblech wahlweise mit verschiedenen Adapterblechen verbunden ist, so dass verschiedene Komponenten über die Adapterbleche mit dem Grundblech verbunden und somit auch die Komponenten vom Grundblech gehalten sind. Das Grundblech selbst wiederum ist vom Kühlkörper des Elektrogeräts gehalten.

Somit ist das Grundblech multifunktional ausgeführt; denn es ist wärmeleitend mit dem Kühlkörper verbunden und führt außerdem eine Haltefunktion aus für wahlweise verbindbare Adapterbleche beziehungswiese damit verbundene Komponenten aus. Zusätzlich ist das Grundblech als elektrisch Erde einsetzbar, also als Schirmauflage und Schirmverbindung für die Schutzleiter von zum Elektrogerät hin geführten Kabeln.

**Erfindungsgemäß** fungiert das Grundblech als Schirmblech,
wobei das Grundblech mit dem metallisch ausgeführten Kühlkörper elektrisch verbunden ist,
insbesondere wobei das Grundblech mit dem Bezugspotential einer elektronischen Schaltung des Elektrogeräts elektrisch verbunden ist,
insbesondere wobei das Bezugspotential elektrisch Erde ist und/oder mit dem Schutzleiter des Elektrogeräts verbunden ist. Von Vorteil ist dabei, dass das Grundblech als Schirmblech fungiert.

Bei einer vorteilhaften Ausgestaltung wird mittels eines Klemmblechs ein Versorgungskabel, insbesondere Drehstromkabel, gegen das Grundblech gedrückt,
insbesondere wobei Schraubenköpfe von ersten Schrauben, deren jeweiliger Gewindebereich in eine jeweilige Gewindebohrung des Grundblechs zumindest teilweise eingeschraubt ist, das Klemmblech auf das Versorgungskabel drücken. Von Vorteil ist dabei, dass das Grundblech zur Zugentlastung und/oder zum Halten und Führen eines Versorgungskabels dient sowie als Verbindung zur elektrischen Erde, also zum Bezugspotential.

Bei einer vorteilhaften Ausgestaltung wird mittels zumindest eines Klemmbügels ein Kabel, insbesondere ein Signalleitungen aufweisendes Kabel, gegen das Grundblech gedrückt, insbesondere wobei ein Schraubenkopf einer jeweiligen zweiten Schraube, deren jeweiliger Gewindebereich in eine jeweilige Gewindebohrung des Grundblechs zumindest teilweise eingeschraubt ist, den Klemmbügel auf das Kabel drückt. Von Vorteil ist dabei, dass das Grundblech Haltefunktion und Zugentlastungsfunktion für das zum Elektrogerät geführte Kabel aufweist.

Bei einer vorteilhaften Ausgestaltung ist das Grundblech derart als Stanz-Biegeteil ausgeführt, dass der vom Kabel berührte Bereich des Grundblechs eben ausgeführt ist,
wobei der vom Versorgungskabel berührte Bereich des Grundblechs eben ausgeführt ist,
wobei die den vom Kabel berührten Bereich des Grundblechs umfassende Ebene parallel und beabstandet ist zu der den vom Versorgungskabel berührten Bereich des Grundblechs umfassenden Ebene. Von Vorteil ist dabei, dass das Kabel und das Versorgungskabel beabstandet voneinander auflegbar sind. Somit sind die zur Datenübertragung verwendeten Signale geringeren Störungen ausgesetzt.

Bei einer vorteilhaften Ausgestaltung ist am Grundblech ein Anschluss für Bezugspotential, insbesondere elektrisch Masse und/oder Schutzleiter, angeordnet,
insbesondere indem eine dritte Schraube in eine Gewindebohrung des Grundblechs eingeschraubt ist, deren Schraubenkopf eine Leitung andrückt, welche mit dem Bezugspotential verbunden ist. Von Vorteil ist dabei, dass das Grundblech als Schirmblech und somit elektrisch Erde fungiert.

Bei einer vorteilhaften Ausgestaltung weist das erste Adapterblech eine Verbindungszunge, insbesondere hervorragende Verbindungszunge auf, welche in oder durch eine Ausnehmung, insbesondere schlitzförmige Ausnehmung des Grundblechs ragt,
insbesondere wobei das erste Adapterblech eine durchgehende Ausnehmung aufweist, durch welche eine durch das Grundblech ragende Schraube durchragt, insbesondere so dass der Schraubenkopf der Schraube das Grundblech zum ersten adapterblech hindrückt,
insbesondere wobei die durchgehende Ausnehmung des ersten Adapterblechs eine Gewindebohrung ist, in welche die durch das Grundblech durchragende Schraube mit ihrem Gewindebereich eingeschraubt ist. Von Vorteil ist dabei, dass das erste Adapterblech formschlüssig verbunden ist mit dem Grundblech. Dabei ist nicht nur die Verbindungszunge in eine Ausnehmung gesteckt, sondern auch eine Schraube schraubverbunden. Auf diese Weise ist eine sichere Verbindung gewährleistet.

Bei einer vorteilhaften Ausgestaltung weist die Komponente eine zur Hutschienenmontage geeignete mechanische Schnittstelle auf und an dieser Schnittstelle ist mit dem Adapterblech verbunden. Von Vorteil ist dabei, dass eine einfache Befestigung ermöglicht ist.

Bei einer vorteilhaften Ausgestaltung weist das erste Adapterblech eine Kante als Rastnase für eine Klipsverbindung auf und weist insbesondere an einem zur Kante gegenüberliegenden Endbereich hervorragende Zungenbereiche auf. Von Vorteil ist dabei, dass eine kostengünstig und einfache Befestigung vorsehbar ist.

Bei einer vorteilhaften Ausgestaltung weist das erste Adapterblech einen zwischen dem am Grundblech anliegenden Bereich des ersten Adapterblechs und dem die Kante und die Zungenbereiche aufweisenden Verbindungsbereich einen Zwischenbereich auf,
insbesondere so, dass das erste Grundblech doppelt abgewinkelt ausgeführt ist,
wobei der Zwischenbereich als seitliche Begrenzung und/oder Anschlag für die im Verbindungsbereich mit dem ersten Adapterblech verbundene Komponente fungiert. Von Vorteil ist dabei, dass der Zwischenbereich einerseits die Oberfläche vergrößert und somit ein teilweises Abströmen des Wärmestroms an die Umgebungsluft bewirkt und andererseits der Verbindungsbereich als Anschlag und somit Begrenzung und/oder alternativ zur Aufnahme des Wärmestroms verwendbar ist, wenn die Komponente am Zwischenbereich anliegt und wärmeleitend verbunden wird. Somit ist die Komponente dann an zwei Seiten entwärmbar, nämlich am Zwischenbereich und an dem Bereich der Verbindung mit dem ersten Adapterblech.

**Erfindungsgemäß** ist die Komponente mit dem ersten Adapterblech wärmeleitend verbunden und/oder berührt an dem Zwischenbereich das erste Adapterblech und ist wärmeleitend verbunden. Von Vorteil ist dabei, dass die Entwärmung der Komponente weiter verbessert ist.

Bei einer vorteilhaften Ausgestaltung ist die Komponente ein Gleichrichter, insbesondere Bremsgleichrichter,
insbesondere wobei der Gleichrichter zur Speisung einer Spule einer elektromagnetisch betätigbaren Bremse eines Bremsmotors ausgeführt ist, dessen Elektromotor aus dem Elektrogerät gespeist ist,
insbesondere wobei das Elektrogerät und der Gleichrichter derart ausgeführt sind, dass dem Kühlkörper nur entweder Verlustwärme von steuerbaren Halbleiterschaltern des Elektrogeräts oder vom Gleichrichter zugeführt wird. Von Vorteil ist dabei, dass die Verlustwärme vom Gleichrichter über den Kühlkörper an die Umgebung abführbar ist. Dabei ist vorzugswiese ein alternatives Belasten des Kühlkörpers ausgeführt, indem entweder Verlustwärme des Elektrogeräts oder Verlustwärme des Gleichrichters zuführbar ist.

Bei einer vorteilhaften Ausgestaltung weist das zweite Adapterblech ebenfalls eine Verbindungszunge, insbesondere hervorragende Verbindungszunge auf, welche in oder durch die Ausnehmung, insbesondere schlitzförmige Ausnehmung, des Grundblechs ragt
insbesondere wobei das zweite Adapterblech eine durchgehende Ausnehmung aufweist, durch welche eine durch das Grundblech ragende Schraube durchragt, insbesondere so dass der Schraubenkopf der Schraube das Grundblech zum zweiten Adapterblech hindrückt,
insbesondere wobei die durchgehende Ausnehmung des zweiten Adapterblechs eine Gewindebohrung ist, in welche die durch das Grundblech durchragende Schraube mit ihrem Gewindebereich eingeschraubt ist. Von Vorteil ist dabei, dass eine einfache und sichere Befestigung ausführbar ist. Außerdem ist somit eine Schnittstelle am Grundblech ausgeprägt, an welcher verschiedene Adapterbleche verbindbar sind.

Bei einer vorteilhaften Ausgestaltung ist der Berührbereich zwischen der Komponente, insbesondere Bremswiederstand, und dem zweiten Adapterblech ebenausgeführt und die den Berührbereich aufnehmende Ebene ist senkrecht zu derjenigen Ebene ausgerichtet, welche den ebenfalls eben ausgeführt Berührbereich zwischen der jeweiligen Komponente und dem ersten Adapterblech umfasst. Von Vorteil ist dabei, dass Wärme entweder parallel zur den Berührbereich zwischen Versorgungskabel und Grundblech aufnehmenden Ebene oder senkrecht hierzu von der Komponente abgebbar ist. Außerdem ist entweder ein für Hutschienenmontage vorgesehene Komponente oder eine an eine Fläche anschraubbare Komponente verbindbar. Dabei wird im letzten Fall das zweite und ansonsten das erste Adapterblech verwendet.

Bei einer vorteilhaften Ausgestaltung ist die Berührfläche zwischen dem zweiten Adapterblech und der Komponente, insbesondere Bremswiderstand, größer als die Berührfläche zwischen dem zweiten Adapterblech und dem Grundblech. Von Vorteil ist dabei, dass ein großer Wärmestrom einbringbar ist, von dem ein Teilstrom direkt vom Grundblech an die Umgebungsluft abströmt und der restliche Wärmestrom über den Kühlkörper abführbar ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von schematischen Abbildungen näher erläutert:

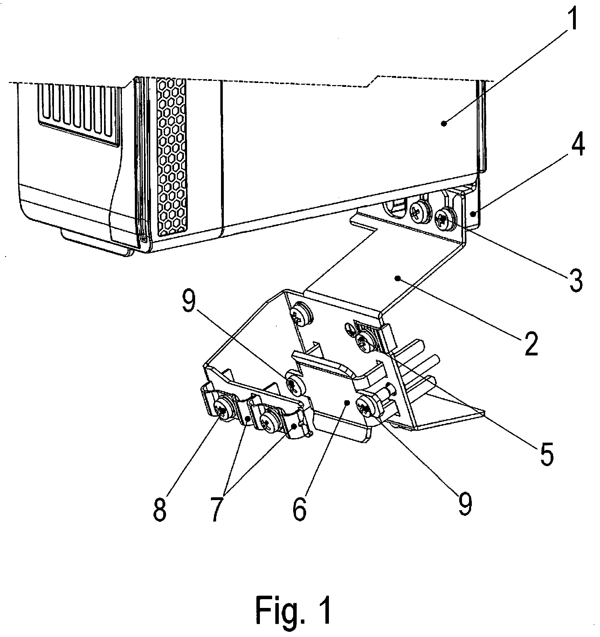

In der Figur 1 ist ein Elektrogerät 1 mit einem Grundblech 2 in Schrägansicht gezeigt, das an einem Kühlkörper 4 des Elektrogeräts 1 mittels Schrauben 3 verbunden ist.
In der Figur 2 ist neben dem Grundblech 2 ein erstes Adapterblech 24 in Schrägansicht dargestellt.

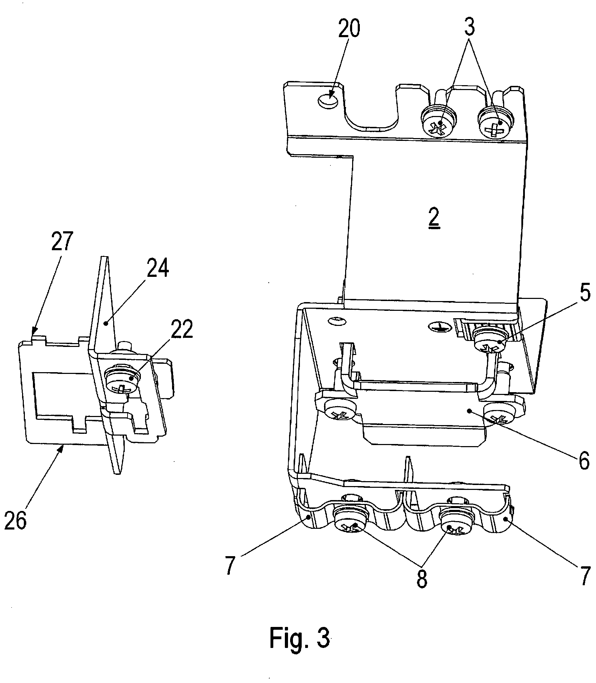

In der Figur 3 ist das Grundblech 2 zusammen mit dem ersten Adapterblech 24 aus einer anderen Blickrichtung als in Figur 2 dargestellt.

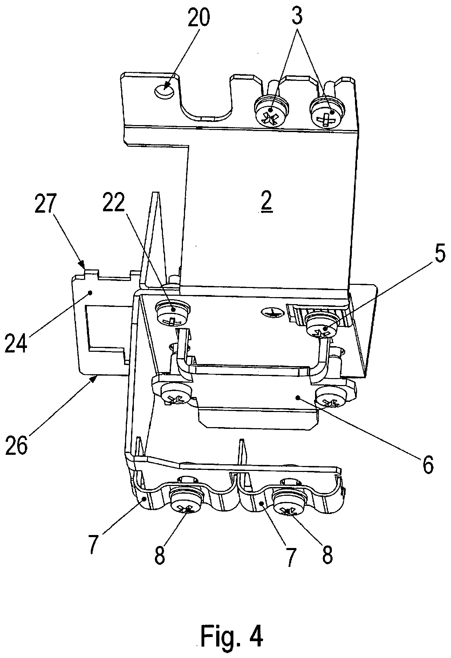

In der Figur 4 ist das erste Adapterblech 24 am Grundblech 2 mittels Schraube 22 verbunden.

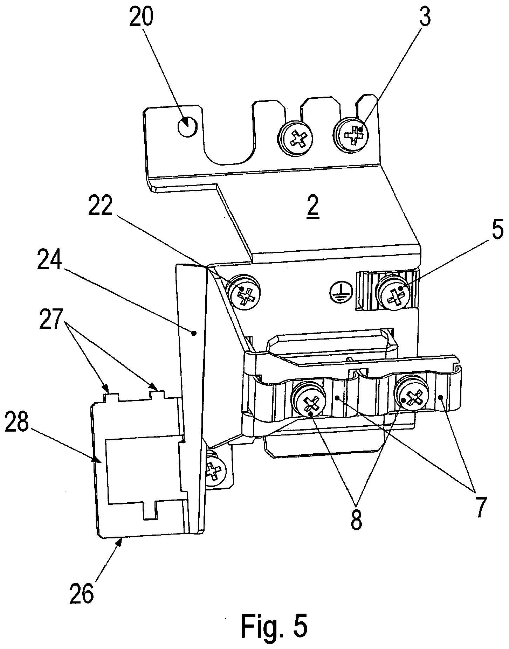

In der Figur 5 ist das am Grundblech 2 angeschraubte erste Adapterblech 24 aus einer anderen Blickrichtung als in Figur 4 dargestellt.
In der Figur 6 ist ein Bremsgleichrichter 60 gezeigt, welcher am ersten Adapterblech 24 befestigt ist.
In der Figur 7 ist der Bremsgleichrichter 60 aus einer anderen Blickrichtung dargestellt.
In der Figur 8 ist ein Anschlussteil 80 anstatt des Bremsgleichrichters 60 am ersten Adapterblech 24 befestigt.
In der Figur 9 ist ein zweites Adapterblech 90 anstelle des ersten Adapterblechs 24 mit dem Grundblech 2 verbunden.

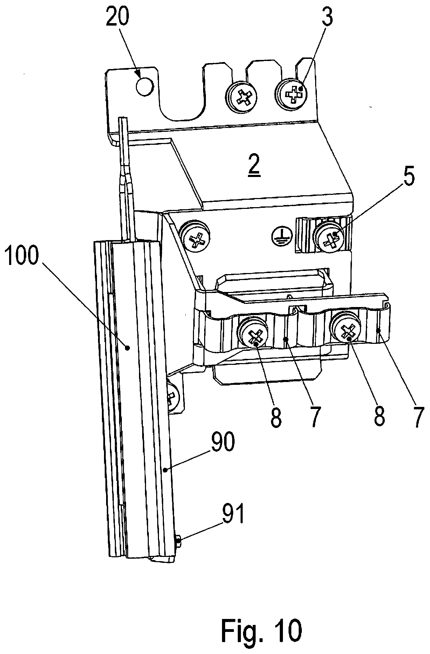

In der Figur 10 ist ein Bremswiderstand 100 mit dem zweiten Adapterblech 24 verbunden.

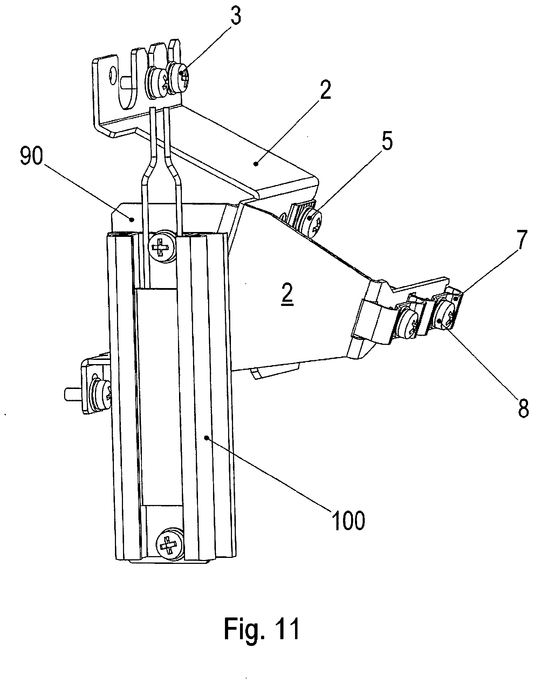

In der Figur 11 ist der Bremswiderstand 100 aus einer anderen Blickrichtung dargestellt.

Wie in den Figuren dargestellt, ist am Elektrogerät 1 ein Grundblech 2 befestigt, insbesondere lösbar verbunden, an welchem entweder ein erstes Adapterblech 24 oder alternativ ein zweites Adapterblech 90 befestigbar ist. Abhängig vom befestigten Adapterblech (24, 90) sind dann verschieden Komponenten, wie Bremsgleichrichter 60, Anschlussteil 80 oder Bremswiderstand 100 befestigbar.

Somit ist ein modularer Aufbau erreichbar, wodurch mit wenigen Bauelementen eine große Varianz von Produkten herstellbar ist.

Das Elektrogerät 1 weist einen Kühlkörper 4 auf, der vorzugsweise als Stranggussteil gefertigt ist. Dieser Kühlkörper 4 ist nicht nur gehäusebildend ausgeführt, sondern bildet die Rückwand des Elektrogeräts 1, mit welcher das Elektrogerät in einem Schaltschrank oder an einer Wand eines Gebäudes befestigbar ist.

Das Elektrogerät 1 ist vorzugsweise als Wechselrichter oder Umrichter ausgeführt und speist einen Elektromotor, wobei hierzu ein Drehstromkabel verwendet wird.

Ebenso ist das Elektrogerät 1 über ein in den Figuren nicht gezeigtes Drehstromkabel versorgt.

Da ein Drehstromkabel zumindest drei Leitungen für die Phasen und eine Leitung für den Nullleiter und/oder Bezugspotential aufweist, ist das Drehstromkabel im Vergleich zu einem Signalleitungen führenden Kabel dick.

Unterhalb des Elektrogeräts 1 ist das Grundblech 2 angeordnet. Das Drehstromkabel ist zwischen einem Klemmblech 6 und dem Grundblech 2 hindurchgeführt und wird vom Klemmblech 6 gegen das Grundblech 2 gedrückt, indem die Schrauben 9 in eine jeweilige Gewindebohrung des Grundblechs 2 eingeschraubt werden und dabei die Schraubenköpfe der Schrauben 9 das Klemmblech 6 zum Grundblech 2 hindrücken.

Das Grundblech 2 ist als Stanz-Biegeteil gefertigt und als metallisches Blechteil elektrisch leitend. Der zum Kühlkörper 4 vorhandene Befestigungsbereich des Grundblechs 2 ist abgewinkelt, also gebogen, zu einem angrenzenden Zwischenbereich des Grundblechs 2, welcher wiederum entgegengesetzt abgewinkelt, also gebogen, ist zu demjenigen Bereich des Grundblechs 2, an welchem das Klemmblech 6 sich befindet. Hiervon ist ein weiterer angrenzender Zwischenbereich abgewinkelt, also abgebogen, angeordnet, von welchem ein Befestigungsbereich abgewinkelt, also abgebogen, vorgesehen ist, an welchem Klemmbügel 7 angeordnet sind, welche von Schrauben 9, die in jeweilige Gewindebohrungen des Befestigungsbereichs eingeschraubt sind, mittels ihrer Schraubenköpfe die Klemmbügel 7 auf in den Figuren nicht gezeigte Kabel drücken.

Dieser Befestigungsbereich für die Klemmbügel 9 ist parallel zum für das Klemmblech 6 vorgesehenen Bereich des Grundblechs 2 ausgerichtet und hiervon beabstandet. Somit ist eine verbesserte Zugänglichkeit erreicht. Die von den Klemmbügeln 7 befestigten Kabel sind ebenfalls zum Elektrogerät 1 geführt und ermöglichen Daten- und/oder Signalübertragung für das Elektrogerät 1.

Am Grundblech 2 ist außerdem ein Masseanschluss angeordnet, indem eine in eine Gewindebohrung des Grundblechs 2 eingeschraubte Schraube 6 ein Anklemmen eines mit einer Masseleitung, insbesondere mit einem Nullleiter oder Schutzleiter, verbundenen Kabelschuhs ans Grundblech 2 ermöglicht.

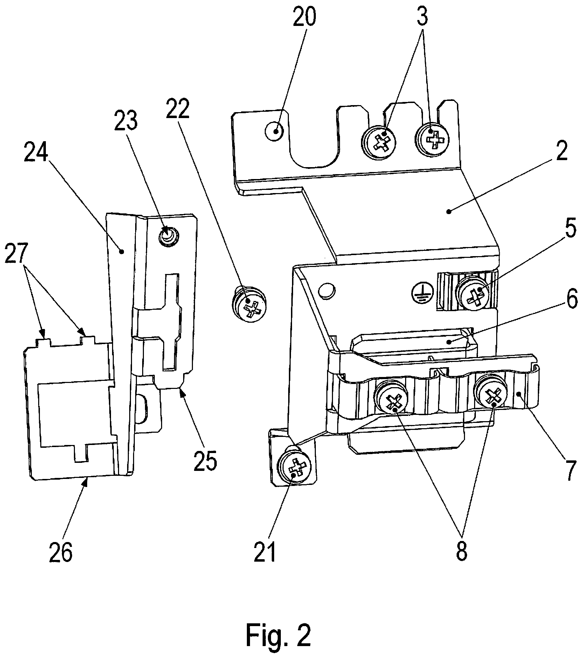

Wie in Figur 2 dargestellt, weist das erste Adapterblech 24 eine hervorragende Verbindungszunge 25 auf, welche in eine insbesondere durchgehende Ausnehmung des Grundblechs 2 hineinragt. Die Ausnehmung ist dabei vorzugsweise als Schlitz ausgeführt.

Zur weiteren Befestigung weist das erste Adapterblech 24 ein durchgehende Ausnehmung 23 zum Zentrieren auf, in welche eine Schraube 22 ragt, welche in eine Gewindebohrung des Grundblechs 2 eingeschraubt ist und deren Gewindebereich auf der vom Schraubenkopf der Schraube 22 abgewandten Seite des Grundblechs hervorragt in die Ausnehmung 23 des ersten Adapterblechs 24.

Das erste Adapterblech 24 ist ebenfalls metallisch und somit elektrisch leitfähig ausgeführt.

Insbesondere doppelt abgewinkelt zu dem am Grundblech 2 anliegenden Bereich des ersten Adapterblechs 24 ist ein Verbindungsbereich 28 am ersten Adapterblech 24 ausgebildet, der eine Hutschienenkante 26 und hervorragende Zungenbereiche 27 derart aufweist, dass Komponenten, die für Hutschienenmontage vorgesehen sind, im Verbindungsbereich 28 des ersten Adapterblechs 24 befestigbar sind.

Die Zungenbereiche 27 sind an der äußeren, der Hutschienenkante gegenüberliegenden Kante des Verbindungsbereichs 28 des ersten Adapterblechs 24 angeordnet.

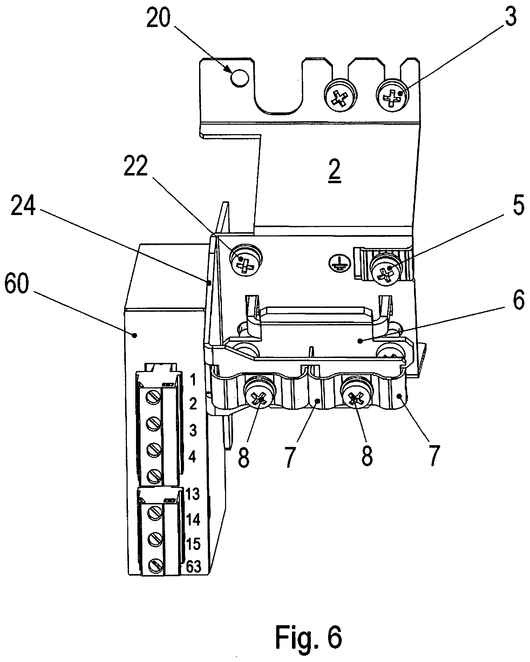

Als Komponente, welche an der Hutschienenkante 26 befestigbar ist, ist gemäß Figur 6 ein Bremsgleichrichter 60 vorgesehen. Dieser Bremsgleichrichter 60 weist einen Gleichrichter auf, der von einer Wechselspannung, insbesondere einer der Phasen des auf dem Drehstromkabel zugeführten Drehstroms, gespeist wird. Der vom Gleichrichter ausgangsseitig erzeugte Gleichstrom wird einer Spule zugeführt, die in einer elektromagnetisch betätigbaren Bremse des vom als Umrichter ausgeführten Elektrogerät 1 gespeisten Elektromotors angeordnet ist. Somit ist die Bremse abhängig von der Bestromung der Spule aktivierbar oder deaktivierbar.

Ein Verlustwärmestrom des Bremsgleichrichters 60 ist über den Verbindungsbereich 28 ans erste Adapterblech 24 und von dort an den Kühlkörper 4 abführbar.

Vorzugsweise weist das Elektrogerät 1 einen Lüfter auf, wobei der von dem Lüfter geförderte Luftstrom am Kühlkörper 4 entlangströmt und somit einen Wärmestrom vom Kühlkörper an die Umgebung weiterleitet.

Der Bremsgleichrichter 60 wäre alternativ auch an einer Hutschiene, die in einem Schaltschrank angeordnet wäre, befestigbar. Durch die am Elektrogerät 1 indirekt angeordnet Montage des Bremsgleichrichters 60 ist dieser am Elektrogerät befestigt und somit mit diesem in einer Anlage anordenbar. Das Elektrogerät 1 bildet zusammen mit dem Bremsgleichrichter 60 eine bauliche Einheit.

Durch das doppelt abgewinkelte Anordnen des Verbindungsbereichs 28 ist eine Beabstandung des Verbindungsbereichs 28 von der die Berührfläche des Kühlkörpers 4 mit der Wand oder mit dem Schaltschrank aufnehmenden Ebene erreichbar. Somit sind die Schrauben und gegebenenfalls verwendete Muttern ungehindert betätigbar.

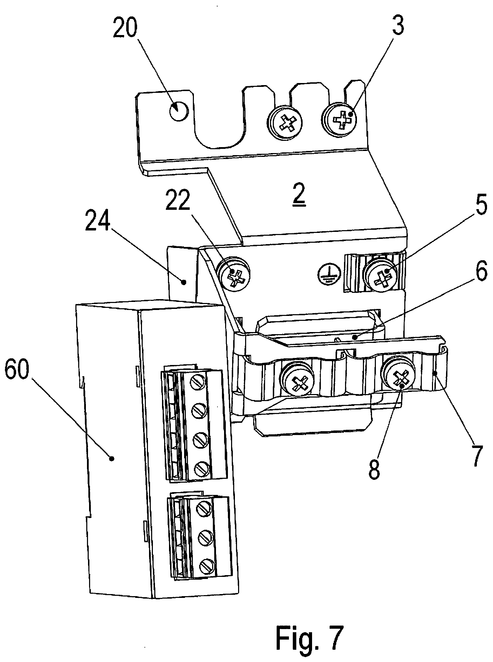

In Figur 7 ist der Bremsgleichrichter aus einem anderen Blickwinkel dargestellt.

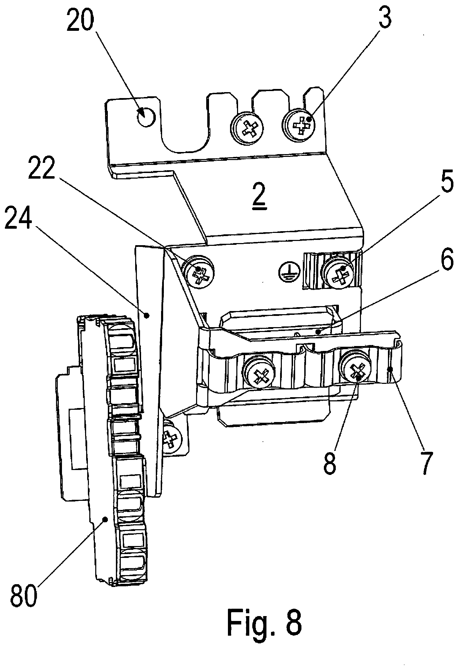

In der Figur 8 ist eine andere Komponente statt des Bremsgleichrichters 60 am Verbindungsbereich 28 befestigt. Diese Komponente ist beispielhaft ein Anschlussteil 80, an welchem Eingang und/oder Ausgänge des Elektrogeräts 1 herausgeführt sind zur elektrischen Kontaktierung. Somit sind Signalleitungen führende Kabel mit einem an ihrem Endbereich konfektionierten Steckverbinder oder alternativ Signalleitungen elektrisch verbindbar.

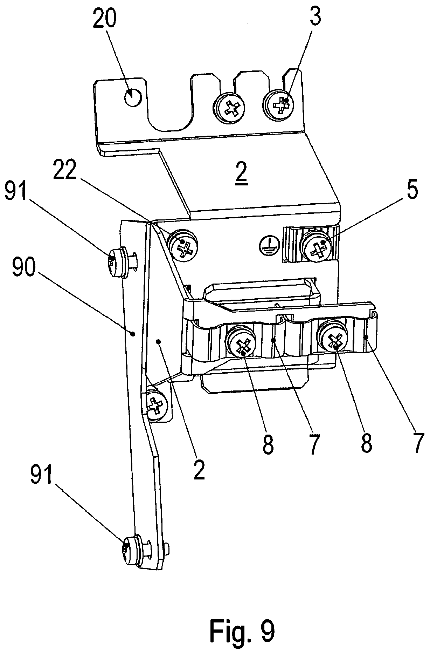

Wie in den Figuren 9ff gezeigt, ist statt des ersten Adapterblechs 24 ein zweites Adapterblech 90 mit dem Grundblech 2 verbindbar, insbesondere in der gleichen Weise wie das erste Adapterblech 24 mit dem Grundblech 2 verbindbar, insbesondere mittels der Schraube 22 ans Grundblech 2 andrückbar.

Das zweite Adapterblech 90 ist abgewinkelt ausgeführt, so dass die Verbindungsfläche zur Verbindung mit einer weiteren Komponente einen nicht verschwindenden Winkel, insbesondere etwa 90°, zur Berührfläche zwischen zweitem Adapterblech 90 und Grundblech 2 aufweist.

Als Komponente ist ein Bremswiderstand 100 vorgesehen. Dieser ist an der Verbindungsfläche des zweiten Adapterblechs 90 angedrückt. Somit ist die Verlustwärme des Bremswiderstands 100 über das zweite Adapterblech 90 an das Grundblech 2 abführbar und von dort an den Kühlkörper 4.

Der Bremswiderstand 100 ist mittels der Schraubenköpfe von Schrauben 91 an das zweite Verbindungsblech 90 andrückbar, welche in Gewindebohrungen des Grundblechs 2 einschraubbar sind.

Das Elektrogerät weist steuerbare Halbleiterschalter auf, insbesondere in parallel zueinander geschalteten Halbbrücken angeordnete Halbleiterschalter. Deren Verlustwärme wird an den Kühlkörper abgeführt, weil diese mit dem Kühlkörper 4 wärmeleitend verbunden sind. Die Halbleiterschalter sind innerhalb eines Gehäuses des Elektrogeräts angeordnet. Um zur Erzeugung eines Drehmoments den Elektromotor mit einem Drehstrom zu speisen, werden die Halbleiterschalter pulsweitenmoduliert betrieben. Dabei entsteht Verlustwärme. Die Bremse ist hierbei gelüftet, so dass der Elektromotor mit einer durch das Drehmoment abhängig vom Lastmoment bewirkten Drehzahl betreibbar ist. Die Bremse ist dabei derart ausführbar, dass beim Lüften der Bremse keine Verlustwärme in dem die Spule der Bremse versorgenden Bremsgleichrichter entsteht. Nur zur Erzeugung von Bremsmoment entsteht dann Verlustwärme im Bremsgleichrichter, wobei dann aber die Halbleiterschalter öffenbar sind und daher keine Verlustwärme erzeugen. Auf diese Weise wird dem Kühlkörper 4 ein Wärmestrom nur entweder von den Halbleiterschaltern des Elektrogeräts 1 oder alternativ vom Gleichrichter 60 zugeführt.

Der Bremsgleichrichter ist in einem vom Elektrogerät 1 separaten, eigenen Gehäuse angeordnet, das am zweiten Adapterblech 90 befestigt ist.

Alternativ ist als Bremse auch eine Haltebremse verwendbar, welche im eingefallenen Zustand keine Verlustwärme erzeugt, insbesondere somit auch nicht im Gleichrichter 60. Nur im gelüfteten Zustand wird dann Verlustwärme im Gleichrichter 60 erzeugt, da dieser dann die Spule der Bremse mit einem Gleichstrom speist. Da aber dann auch die Halbleiterschalter pulsweitenmoduliert betrieben werden und somit Verlustwärme, insbesondere infolge von Schaltverlusten, erzeugen, wird dem Kühlkörper 4 dann sowohl von den Halbleiterschaltern als auch von dem Gleichrichter 60 Verlustwärme zugeführt.

Auch das Grundblech 2 und das jeweils vorgesehene Adapterblech (24, 90) führen einen Teil des Wärmestroms an die Umgebung ab, da der vom im Elektrogerät 1 angeordnete Lüfter den Luftstrom entlang des Kühlkörpers 4 fördert, aber das Grundblech 2 derart abgewinkelt vor der Mündung des für den geförderten Luftstrom vorgesehenen Kanals angeordnet ist, dass der geförderte Luftstrom umgelenkt wird von dem Grundblech2.

Somit ist das Grundblech 2 nicht nur mit dem Kühlkörper 4 wärmeleitend verbunden, sondern lenkt auch den insbesondere in das Gerät einströmenden Luftstrom um. Dies ist besonders vorteilhaft, wenn der Luftstrom von der Umgebung und somit von der Wand entfernt umgeleitet wird.

Das Grundblech 2 vergrößert aber auch die Wärmekapazität des Kühlkörpers 4.

Bei weiteren erfindungsgemäßen Ausführungsbeispielen wird statt des einströmenden Luftstroms der ausströmende Luftstrom umgelenkt.

### Bezugszeichenliste

1 Elektrogerät, insbesondere Wechselrichter oder Umrichter
2 Grundblech
3 Schraube
4 Kühlkörper
5 Schraube
6 Klemmblech
7 Klemmbügel
8 Schraube
9 Schraube
20 Zentrierloch
21 Schraube
22 Schraube
23 Ausnehmung, insbesondere Loch
24 erstes Adapterblech
25 Verbindungszunge
26 Hutschienenkante
27 Zungenbereich
28 Verbindungsbereich
60 Gleichrichter
80 Anschlussteil
90 zweites Adapterblech
91 Schraube
100 Bremswiderstand

## Patentansprüche

1. Anordnung mit Elektrogerät (1), insbesondere Umrichter oder Wechselrichter, und Komponente,
wobei das Elektrogerät (1) einen Kühlkörper (4) aufweist,
**wobei** am Kühlkörper (4) ein Grundblech (2) befestigt ist und die Komponente mit einem am Grundblech (2) befestigten, ersten oder zweiten Adapterblech (24, 90) verbunden ist,
insbesondere wobei das Grundblech (2) vom Schraubenkopf einer in eine Gewindebohrung des Kühlkörpers eingeschraubten Schraube (3) an den Kühlkörper (4) angedrückt ist,
**dadurch gekennzeichnet, dass**
**das Grundblech (2) als Schirmblech fungiert,**
**wobei das Grundblech (2) mit dem metallisch ausgeführten Kühlkörper (4) elektrisch verbunden ist,**
**wobei das Grundblech (2) zum Halten eines Versorgungskabels dient,**
**wobei die Komponente mit dem ersten oder zweiten Adapterblech (24, 90) wärmeleitend verbunden ist.**

2. Anordnung nach Anspruch 1,
**dadurch gekennzeichnet, dass**
mittels eines Klemmblechs (6) ein Versorgungskabel, insbesondere Drehstromkabel, gegen das Grundblech (2) gedrückt wird,
insbesondere wobei Schraubenköpfe von ersten Schrauben (3), deren jeweiliger Gewindebereich in eine jeweilige Gewindebohrung des Grundblechs (2) zumindest teilweise eingeschraubt ist, das Klemmblech (6) auf das Versorgungskabel drücken.

3. Anordnung nach einem der vorangegangenen Ansprüche,
**dadurch gekennzeichnet, dass**
mittels zumindest eines Klemmbügels (7) ein Kabel, insbesondere ein Signalleitungen aufweisendes Kabel, gegen das Grundblech (2) gedrückt wird,
insbesondere wobei ein Schraubenkopf einer jeweiligen zweiten Schraube (3), deren jeweiliger Gewindebereich in eine jeweilige Gewindebohrung des Grundblechs (2) zumindest teilweise eingeschraubt ist, den Klemmbügel (7) auf das Kabel drückt.

4. Anordnung nach einem der vorangegangenen Ansprüche,
**dadurch gekennzeichnet, dass**
das Grundblech (2) derart als Stanz-Biegeteil ausgeführt ist, dass
der vom Kabel berührte Bereich des Grundblechs (2) eben ausgeführt ist,
wobei der vom Versorgungskabel berührte Bereich des Grundblechs (2) eben ausgeführt ist,
wobei die den vom Kabel berührten Bereich des Grundblechs (2) umfassende Ebene parallel und beabstandet ist zu der den vom Versorgungskabel berührten Bereich des Grundblechs (2) umfassenden Ebene.

5. Anordnung nach einem der vorangegangenen Ansprüche,
**dadurch gekennzeichnet, dass**
am Grundblech (2) ein Anschluss für Bezugspotential, insbesondere elektrisch Masse und/oder Schutzleiter, angeordnet ist,
insbesondere indem eine dritte Schraube (3) in eine Gewindebohrung des Grundblechs (2) eingeschraubt ist, deren Schraubenkopf eine Leitung andrückt, welche mit dem Bezugspotential verbunden ist.

6. Anordnung nach einem der vorangegangenen Ansprüche,
**dadurch gekennzeichnet, dass**
das erste Adapterblech (24) eine Verbindungszunge (25), insbesondere hervorragende Verbindungszunge (25) aufweist, welche in oder durch eine Ausnehmung (23), insbesondere schlitzförmige Ausnehmung (23) des Grundblechs (2) ragt,
insbesondere wobei das erste Adapterblech (24) eine durchgehende Ausnehmung (23) aufweist, durch welche eine durch das Grundblech (2) ragende Schraube (3) durchragt, insbesondere so dass der Schraubenkopf der Schraube (3) das Grundblech (2) zum ersten Adapterblech (24) hindrückt,
insbesondere wobei die durchgehende Ausnehmung (23) des ersten Adapterblechs (24) eine Gewindebohrung ist, in welche die durch das Grundblech (2) durchragende Schraube (3) mit ihrem Gewindebereich eingeschraubt ist.

7. Anordnung nach einem der vorangegangenen Ansprüche,
**dadurch gekennzeichnet, dass**
die Komponente eine zur Hutschienenmontage geeignete mechanische Schnittstelle aufweist und an dieser Schnittstelle mit dem Adapterblech (24) verbunden ist.
und/oder dass
das erste Adapterblech (24) eine Kante als Rastnase für eine Klipsverbindung aufweist und insbesondere an einem zur Kante gegenüberliegenden Endbereich hervorragende Zungenbereiche aufweist.

8. Anordnung nach einem der vorangegangenen Ansprüche,
**dadurch gekennzeichnet, dass**
das erste Adapterblech (24) einen zwischen dem am Grundblech (2) anliegenden Bereich des ersten Adapterblechs (24) und dem die Kante und die Zungenbereiche aufweisenden Verbindungsbereich (28) einen Zwischenbereich aufweist,
insbesondere so, dass das erste Grundblech (2) doppelt abgewinkelt ausgeführt ist,
wobei der Zwischenbereich als seitliche Begrenzung und/oder Anschlag für die im Verbindungsbereich (28) mit dem ersten Adapterblech (24) verbundene Komponente fungiert.

9. Anordnung nach einem der vorangegangenen Ansprüche,
**dadurch gekennzeichnet, dass**
die Komponente ein Gleichrichter, insbesondere Bremsgleichrichter, ist,
insbesondere wobei der Gleichrichter (60) zur Speisung einer Spule einer elektromagnetisch betätigbaren Bremse eines Bremsmotors ausgeführt ist, dessen Elektromotor aus dem Elektrogerät (1) gespeist ist,
insbesondere wobei das Elektrogerät (1) und der Gleichrichter (60) derart ausgeführt sind, dass dem Kühlkörper (4) nur entweder Verlustwärme von steuerbaren Halbleiterschaltern des Elektrogeräts (1) oder vom Gleichrichter (60)zugeführt wird.

10. Anordnung nach einem der vorangegangenen Ansprüche,
**dadurch gekennzeichnet, dass**
das zweite Adapterblech (90) ebenfalls eine Verbindungszunge (25), insbesondere hervorragende Verbindungszunge (25) aufweist, welche in oder durch die Ausnehmung (23), insbesondere schlitzförmige Ausnehmung (23), des Grundblechs (2) ragt,
insbesondere wobei das zweite Adapterblech (90) eine durchgehende Ausnehmung (23) aufweist, durch welche eine durch das Grundblech (2) ragende Schraube (3) durchragt, insbesondere so dass der Schraubenkopf der Schraube (3) das Grundblech (2) zum zweiten Adapterblech (90) hindrückt,
insbesondere wobei die durchgehende Ausnehmung (23) des zweiten Adapterblechs (90) eine Gewindebohrung ist, in welche die durch das Grundblech (2) durchragende Schraube (3) mit ihrem Gewindebereich eingeschraubt ist.

11. Anordnung nach einem der vorangegangenen Ansprüche,
**dadurch gekennzeichnet, dass**
der Berührbereich zwischen der Komponente, insbesondere Bremswiederstand, und dem zweiten Adapterblech (90) ebenausgeführt ist und die den Berührbereich aufnehmende Ebene senkrecht zu derjenigen Ebene ausgerichtet ist, welche den ebenfalls eben ausgeführt Berührbereich zwischen der jeweiligen Komponente und dem ersten Adapterblech (24) umfasst.

12. Anordnung nach einem der vorangegangenen Ansprüche,
**dadurch gekennzeichnet, dass**
die Berührfläche zwischen dem zweiten Adapterblech (90) und der Komponente, insbesondere Bremswiderstand (100), größer ist als die Berührfläche zwischen dem zweiten Adapterblech (90) und dem Grundblech (2).

## Claims

1. Arrangement comprising an electrical device (1), in particular a converter or an inverter, and a component,
the electrical device (1) comprising a cooling member (4),
a base plate (2) being fastened to the cooling member (4), and the component being connected to a first or second adapter plate (24, 90) fastened to the base plate (2),
the base plate (2) in particular being pressed onto the cooling member (4) by the screw head of a screw (3) that is screwed into a threaded bore in the cooling member,
**characterised in that**
the base plate (2) acts as a shielding plate,
the base plate (2) being electrically connected to the cooling member (4), which is metallic, the base plate (2) being used for retaining a power supply cable,
the component being connected to the first or second adapter plate (24, 90) in a heat-conducting manner.

2. Arrangement according to claim 1,
**characterised in that**
a power supply cable, in particular a three-phase cable, is pressed against the base plate (2) by means of a clamping plate (6),
screw heads of first screws (3), the threaded region of each of which is at least partly screwed into a respective threaded bore in the base plate (2), in particular pressing the clamping plate (6) onto the power supply cable.

3. Arrangement according to any of the preceding claims,
**characterised in that**
a cable, in particular a cable comprising signal lines, is pressed against the base plate (2) by means of at least one terminal clamp (7),
a screw head of a particular second screw (3), the threaded region of which is at least partly screwed into a respective threaded bore in the base plate (2), in particular pressing the terminal clamp (7) onto the cable.

4. Arrangement according to any of the preceding claims,
**characterised in that**
the base plate (2) is configured as a punched and bent part such that the region of the base plate (2) that is contacted by the cable is configured to be planar,
the region of the base plate (2) that is contacted by the power supply cable being configured to be planar,
the plane that encompasses the region of the base plate (2) that is contacted by the cable being parallel with and at a distance from the plane that encompasses the region of the base plate (2) that is contacted by the power supply cable.

5. Arrangement according to any of the preceding claims,
**characterised in that**
a terminal for reference potential, in particular electrical earth and/or a protective earth conductor, is arranged on the base plate (2),
in particular by screwing a third screw (3), the screw head of which presses on a line connected to the reference potential, into a threaded bore in the base plate (2).

6. Arrangement according to any of the preceding claims,
**characterised in that**
the first adapter plate (24) comprises a connecting tongue (25), in particular a protruding connecting tongue (25), which projects into or through an opening (23), in particular a slot-like opening (23), in the base plate (2),
the first adapter plate (24) in particular comprising a through-opening (23) through which there projects a screw (3) that projects through the base plate (2), in particular such that the screw head of the screw (3) presses the base plate (2) towards the first adapter plate (24), the through-opening (23) in the first adapter plate (24) in particular being a threaded bore into which the screw (3) that projects through the base plate (2) is screwed by its threaded region.

7. Arrangement according to any of the preceding claims,
**characterised in that**
the component comprises a mechanical interface, which is suitable for DIN rail assembly, and is connected to the adapter plate (24) at this interface,
and/or **in that**
the first adapter plate (24) comprises an edge as a snap-in lug for a clip connection, and in particular comprises protruding tongue regions on an end region opposite the edge.

8. Arrangement according to any of the preceding claims,
**characterised in that**
the first adapter plate (24) comprises an intermediate region between the region of the first adapter plate (24) that abuts the base plate (2) and the connection region (28) that comprises the edge and the tongue regions,
in particular such that the first base plate (2) is configured to be double-angled,
the intermediate region acting as a lateral limit and/or stop for the component that is connected to the first adapter plate (24) in the connection region (28).

9. Arrangement according to any of the preceding claims,
**characterised in that**
the component is a rectifier, in particular a brake rectifier,
the rectifier (60) being configured to feed a coil of an electromagnetically actuable brake of a braking motor, the electric motor of which is fed from the electrical device (1),
the electrical device (1) and the rectifier (60) in particular being configured such that the cooling member (4) is supplied with heat lost from only controllable semiconductor switches of the electrical device (1) or from only the rectifier (60).

10. Arrangement according to any of the preceding claims,
**characterised in that**
the second adapter plate (90) likewise comprises a connecting tongue (25), in particular a protruding connecting tongue (25), which projects into or through the opening (23), in particular a slot-like opening (23), in the base plate (2),
the second adapter plate (90) in particular comprising a through-opening (23) through which there projects a screw (3) that projects through the base plate (2), in particular such that the screw head of the screw (3) presses the base plate (2) towards the second adapter plate (90),
the through-opening (23) in the second adapter plate (90) in particular being a threaded bore into which the screw (3) that projects through the base plate (2) is screwed by its threaded region.

11. Arrangement according to any of the preceding claims,
**characterised in that**
the contact region between the component, in particular the braking resistor, and the second adapter plate (90) is configured to be planar, and the plane incorporating this contact region is oriented perpendicularly to the plane that encompasses the likewise planar contact region between the particular component and the first adapter plate (24).

12. Arrangement according to any of the preceding claims,
**characterised in that**
the contact surface between the second adapter plate (90) and the component, in particular the braking resistor (100), is larger than the contact surface between the second adapter plate (90) and the base plate (2).

## Revendications

1. Ensemble comprenant un appareil électrique (1), en particulier un convertisseur ou un onduleur, et un composant,
l'appareil électrique (1) présentant un corps de refroidissement (4),
une plaque de base (2) étant fixée au corps de refroidissement (4) et le composant étant relié à une première ou une seconde plaque adaptatrice (24, 90) fixée à la plaque de base (2),
la plaque de base (2) étant en particulier pressée contre le corps de refroidissement (4) par la tête de vis d'une vis (3) vissée dans un alésage fileté du corps de refroidissement,
**caractérisé en ce que**
la plaque de base (2) fait office de plaque de protection,
la plaque de base (2) étant reliée électriquement au corps de refroidissement (4) métallique,
la plaque de base (2) servant à retenir un câble d'alimentation,
le composant étant relié de manière thermoconductrice à la première ou à la seconde plaque adaptatrice (24, 90).

2. Ensemble selon la revendication 1,
**caractérisé en ce que**
un câble d'alimentation, en particulier un câble triphasé, est pressé contre la plaque de base (2) au moyen d'une plaque de serrage (6),
les têtes de vis des premières vis (3), dont la région filetée respective est au moins partiellement vissée dans un alésage fileté respectif de la plaque de base (2), pressant en particulier la plaque de serrage (6) sur le câble d'alimentation.

3. Ensemble selon l'une quelconque des revendications précédentes,
**caractérisé en ce que**
un câble, en particulier un câble présentant des lignes de signal, est pressé contre la plaque de base (2) au moyen d'au moins un étrier de serrage (7),
une tête de vis d'une deuxième vis (3) respective, dont la région filetée respective est au moins partiellement vissée dans un alésage fileté respectif de la plaque de base (2), pressant en particulier l'étrier de serrage (7) sur le câble.

4. Ensemble selon l'une quelconque des revendications précédentes,
**caractérisé en ce que**
la plaque de base (2) est réalisée sous la forme d'une pièce pliée par estampage de telle manière que
la région de la plaque de base (2) en contact avec le câble est plane,
la région de la plaque de base (2) en contact avec le câble d'alimentation étant plane, le plan englobant la région de la plaque de base (2) en contact avec le câble étant parallèle et espacé par rapport au plan englobant la région de la plaque de base (2) en contact avec le câble d'alimentation.

5. Ensemble selon l'une quelconque des revendications précédentes,
**caractérisé en ce que**
un raccordement destiné au potentiel de référence, en particulier à la masse électrique et/ou au conducteur de protection, est agencé sur la plaque de base (2),
en particulier en vissant dans un alésage fileté de la plaque de base (2) une troisième vis (3) dont la tête de vis appuie sur une ligne qui est reliée au potentiel de référence.

6. Ensemble selon l'une quelconque des revendications précédentes,
**caractérisé en ce que**
la première plaque adaptatrice (24) présente une languette de liaison (25), en particulier une languette de liaison (25) saillante qui fait saillie dans ou à travers un évidement (23), en particulier un évidement (23) en forme de fente, de la plaque de base (2),
la première plaque adaptatrice (24) présentant en particulier un évidement traversant (23) à travers lequel passe une vis (3) faisant saillie à travers la plaque de base (2), en particulier de sorte que la tête de vis de la vis (3) pousse la plaque de base (2) vers la première plaque adaptatrice (24),
l'évidement traversant (23) de la première plaque adaptatrice (24) étant en particulier un alésage fileté dans lequel est vissée la région filetée de la vis (3) traversant la plaque de base (2).

7. Ensemble selon l'une quelconque des revendications précédentes,
**caractérisé en ce que**
le composant présente une interface mécanique appropriée pour le montage sur rail DIN et est relié à ladite interface grâce à la plaque adaptatrice (24),
et/ou **en ce que**
la première plaque adaptatrice (24) présente un bord faisant office de nez d'encliquetage pour une liaison par clip et présente en particulier des régions de languette faisant saillie au niveau d'une région d'extrémité opposée au bord.

8. Ensemble selon l'une quelconque des revendications précédentes,
**caractérisé en ce que**
la première plaque adaptatrice (24) présente une région intermédiaire entre la région, adjacente à la plaque de base (2), de la première plaque adaptatrice (24) et la région de liaison (28) présentant le bord et les régions de languette,
en particulier de sorte que la première plaque de base (2) est réalisée de manière doublement coudée,
la région intermédiaire servant de délimitation latérale et/ou de butée pour le composant relié à la première plaque adaptatrice (24) dans la région de liaison (28).

9. Ensemble selon l'une quelconque des revendications précédentes,
**caractérisé en ce que**
le composant est un redresseur, en particulier un redresseur de frein,
le redresseur (60) étant en particulier conçu pour alimenter une bobine d'un frein à commande électromagnétique d'un moteur de frein dont le moteur électrique est alimenté par l'appareil électrique (1),
l'appareil électrique (1) et le redresseur (60) étant en particulier conçus de telle manière que seule la chaleur de dissipation provenant des commutateurs à semiconducteurs pilotables de l'appareil électrique (1) ou du redresseur (60) est conduite jusqu'au corps de refroidissement (4).

10. Ensemble selon l'une quelconque des revendications précédentes,
**caractérisé en ce que**
la seconde plaque adaptatrice (90) présente également une languette de liaison (25), en particulier une languette de liaison (25) faisant saillie, qui pénètre dans ou à travers l'évidement (23), en particulier l'évidement en forme de fente (23), de la plaque de base (2),
la seconde plaque adaptatrice (90) présentant en particulier un évidement traversant (23) à travers lequel passe une vis (3) faisant saillie à travers la plaque de base (2), en particulier de sorte que la tête de vis de la vis (3) pousse la plaque de base (2) vers la seconde plaque adaptatrice (90),
l'évidement traversant (23) de la seconde plaque adaptatrice (90) étant en particulier un alésage fileté dans lequel est vissée la région filetée de la vis (3) traversant la plaque de base (2).

11. Ensemble selon l'une quelconque des revendications précédentes,
**caractérisé en ce que**
la région de contact entre le composant, en particulier la résistance de freinage, et la seconde plaque adaptatrice (90) est réalisée de manière plane et le plan accueillant la région de contact est orienté perpendiculairement au plan qui comprend la région de contact, également réalisée de manière plane, entre le composant respectif et la première plaque adaptatrice (24).

12. Ensemble selon l'une quelconque des revendications précédentes,
**caractérisé en ce que**
la surface de contact entre la seconde plaque adaptatrice (90) et le composant, en particulier la résistance de freinage (100), est plus grande que la surface de contact entre la seconde plaque adaptatrice (90) et la plaque de base (2).
